# EUROPEAN PATENT SPECIFICATION

(11) **EP 1 601 984 B1**
(45) Date of publication and mention of the grant of the patent: **15.08.2007**
(21) Application number: 04715833.2
(22) Date of filing: 28.02.2004
(51) Int. Cl.: G01R 31/3185

(54) **AUTOMATICALLY DETECTING AND ROUTING OF TEST SIGNALS**
AUTOMATISCHES DETEKTIEREN UND ROUTEN VON TESTSIGNALEN
DETECTION ET ACHEMINEMENT AUTOMATIQUE DE SIGNAUX D'ESSAI

(30) Priority: 04.03.2003 US 452095 P
(43) Date of publication of application: 07.12.2005
(73) Proprietor: Koninklijke Philips Electronics N.V., 5621 BA Eindhoven (NL)
(72) Inventor: AVERY, Daniel, Lee, San Jose, CA 95131 (US); BAILEY, Joel, San Jose, CA 95131 (US)
(74) Representative: Damen, Daniel Martijn
(86) International application number: PCT/IB2004/000528
(87) International publication number: WO 2004/079382

(56) References cited:
- WO-A-02/29568
- US-A- 5 636 227
- US-A1- 2003 041 235
- ING-JER HUANG ET AL: "ICEBERG: an embedded in-circuit emulator synthesizer for microcontrollers" DESIGN AUTOMATION CONFERENCE, 1999. PROCEEDINGS. 36TH NEW ORLEANS, LA, USA 21-25 JUNE 1999, PISCATAWAY, NJ, USA,IEEE, US, 21 June 1999 (1999-06-21), pages 580-585, XP010343968 ISBN: 1-58113-092-9
- "JTAG CONTROLLED TESTPOINT SELECT MECHANISM" IBM TECHNICAL DISCLOSURE BULLETIN, IBM CORP. NEW YORK, US, vol. 37, no. 2B, 1 February 1994 (1994-02-01), page 157, XP000433793 ISSN: 0018-8689

## Description

The present invention relates generally to testing integrated circuits (ICs) and, more particularly, to IC test methods and arrangements such as used in connection with IEEE JTAG (Joint Test Access Group) standards and others involving digital test signals and digital signal protocols.

The electronics industry continues to rely upon advances in semiconductor technology to realize higher-functioning devices in more compact areas. For many applications, realizing higher-functioning devices requires integrating a large number of electronic devices into a single silicon wafer. As the number of electronic devices per given area of the silicon wafer increases, manufacturing and testing processes become more difficult.

A wide variety of techniques have been used in integrated circuit (IC) devices to ensure that, once they are manufactured, they operate fully in compliance with their intended design and implementation specifications. Many of the more complex IC designs include circuits that permit in-circuit testing via the IC access pins. The IEEE 1149.1 JTAG recommendation, for example, provides test circuit architecture for use inside such ICs. This architecture includes a test access port (TAP) controller coupled to the IC pins for providing access to and for controlling various standard features designed into such ICs. Some of these features are internal scan, boundary scan, built-in test and emulation.

For a variety of implementations, different circuit paths are tested using the JTAG recommendation, depending upon the type of test being performed. Mechanical connections (i.e., jumpers) have typically been used to select such a desired circuit path for JTAG-type testing. Setting mechanical connections, however, typically requires access to the connections being set. For example, circuit modules (e.g., permanent and/or reusable blocks and ICs) can be stacked on top of one another, such that in setting jumpers the circuit modules must be pulled apart. If mistakes are made in setting the jumpers, the process of pulling apart the modules and setting the jumpers must be repeated. The implementation of this mechanical connection-setting approach has been challenging. For example, taking apart modules for making connections involves a risk of damaging the connectors, boards and/or other circuitry involved therewith.

In addition, for many chip designs, customized chips are made by describing their functionality using a hardware-description language (HDL), such as Verilog or VHDL. The hardware description is often written to characterize the design in terms of a set of functional macros. The design is computer simulated to ensure that the custom design criteria are satisfied. An example of a customized chip is given in 'ICEBERG, an embedded in-circuit emulator synthesizer for microcontrollers by Huang et al. in: Proc. Of the 36th Design Automation Conference, New Orleans, LA, USA 21-25 June 1999, pages 580-585, in which a modified chip is disclosed in which the JTAG circuitry of the disclosed circuit is enhanced with dedicated debug registers to facilitate silicon debug.

For highly-complex custom chip designs, the above process can be burdensome and costly. The highly integrated structure of such chips leads to unexpected problems, such as signal timing, noise-coupling and signal-level issues. Consequently, such complex custom chip designs involve extensive validation. This validation is generally performed at different stages using a Verilog or VHDL simulator. Once validated at this level, the Verilog or VHDL HDL code is synthesized, for example, using "Synopsis," to a netlist that is supplied to an ASIC (Application Specific Integrated Circuit) foundry for prototype fabrication. The ASIC prototype is then tested in silicon. Even after such validation with the Verilog or VHDL simulator, unexpected problems are typical.

Overcoming these problems involves more iterations of the above process, with testing and validation at both the simulation and prototype stages. Such repetition significantly increases the design time and cost to such a degree that this practice is often intolerable in today's time-sensitive market. These and other difficulties present challenges to the design and testing for a variety of applications. Various aspects of the present invention involve testing approaches for a variety of integrated circuits, such as those including memory circuits and others. The present invention is exemplified in a number of implementations and applications, some of which are summarized below.

According to one example embodiment of the present invention, a controllable switch is operated to couple test signals via a selected circuit path, the switch being controlled in response to the test signals being detected at an input node. With this approach, switching for routing test data is automatically effected, without necessarily involving manual switching approaches, such as those involving the use of jumpers.

In a more particular example embodiment of the present invention, a microcontroller is programmed to automatically monitor test data inputs (TDIs) for testing signals. Upon the detection of a test signal, the microcontroller identifies a particular circuit path to which the test data is to be routed, and controls a switch for routing the test signal between the TDIs and the circuit path. In a more particular implementation, the microcontroller is further programmed to control a switch for routing a response to the test signal to a test data output (TDO).

In another example embodiment of the present invention, an inter-connectable circuit board includes a plurality of circuit paths and controllable switches adapted for routing test data between at least of the circuit paths and a communications node. A microcontroller is programmed for controlling the controllable switches in response to signals monitored at the communications node. In response to detecting a test signal at the communications node, the microcontroller is programmed for identifying a particular one of the circuit paths to which the test signal is to be routed. The microcontroller then controls the controllable switches to couple a signal path between the communications node and the circuit path. With this approach, access to the inter-connectable circuit board, for example, for connecting jumper lines for switching circuits, is not necessary. This approach has also been found useful when the inter-connectable circuit board is connected to another arrangement such that physical access to the inter-connectable circuit board is difficult or not possible.

In another example embodiment, one or more of the circuit paths discussed in the above paragraph include paths for routing test data between the inter-connectable circuit board and another inter-connectable circuit board. The microcontroller detects the presence of the other inter-connectable circuit board in response to the monitored signals and controls the controllable switches for routing data to and from the other inter-connectable circuit board.

The above summary of the present invention is not intended to describe each embodiment or every implementation of the present invention. The above summary of the present invention is not intended to describe each illustrated embodiment or every implementation of the present invention. The figures and detailed description that follow more particularly exemplify these embodiments.

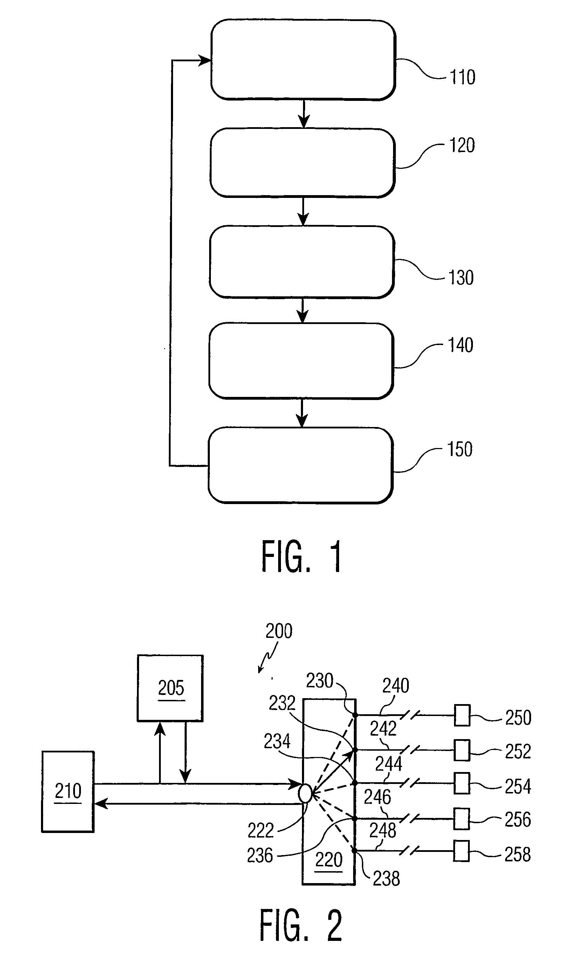

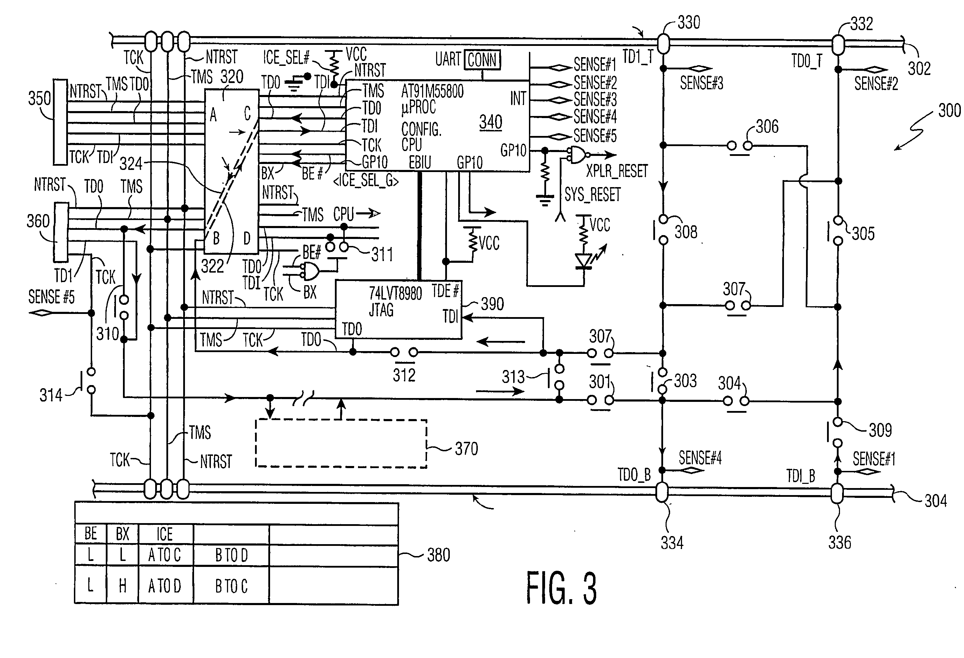

## Claims

1. A microcomputer arrangement (200) communicatively coupled to JTAG test nodes (210), the microcomputer arrangement comprising:
a controllable switch arrangement (220) communicatively coupled between the JTAG test nodes and at least two JTAG signal paths (240, 246); and
a microcontroller (205) communicatively coupled to the JTAG test nodes and programmed to control the controllable switch arrangement to route data between at least one of the JTAG test nodes and at least one of the JTAG signal paths, **characterized in that** the microcontroller is:
arranged to monitor the JTAG test nodes to automatically detect a test signal at one of the JTAG test nodes; and
programmed to control the controllable switch arrangement in response to the automatically detected test signal.

2. The microcomputer arrangement of claim 1, wherein the microcontroller is programmed for controlling the controllable switch arrangement to route data between the JTAG test nodes and a particular device along one of the JTAG signal paths for performing a JTAG test on the particular device.

3. The microcomputer arrangement of claim 1, wherein the microcontroller is programmed to monitor the JTAG test nodes using an interrupt routine for automatically detecting the test signal.

4. The microcomputer arrangement of claim 3, wherein the microcontroller is programmed to monitor the JTAG test nodes using a plurality of interrupt routines, each of the plurality of interrupt routines being adapted for monitoring one of the JTAG test nodes for detecting a test signal thereon, the microcontroller being adapted for routing the data between the monitored JTAG test node and at least one of the JTAG signal paths in response to the interrupt routine detecting a test signal on the monitored JTAG test node.

5. The microcomputer arrangement of claim 4, wherein each interrupt routine is assigned to a single JTAG test node and wherein the microcontroller is programmed to control the controllable switch to route data between a particular JTAG test node and one of the JTAG signal paths as a function of the assignment of the particular interrupt routine that detects a test signal.

6. The microcomputer arrangement of claim 1, wherein the controllable switch arrangement is adapted to route data along a JTAG signal path from a first JTAG test node to a second JTAG test node in response to the microcontroller.

7. The microcomputer arrangement of claim 1, wherein the controllable switch arrangement is adapted to route data along a JTAG signal path from a first JTAG test node to a device that responds to the data and to route a response of the device to a JTAG test output node.

8. The microcomputer arrangement of claim 7, wherein the device includes at least one of:
an FPGA device, an FPGA plug-in board, an expansion board and an external circuit communicatively coupled with the microcontroller.

9. The microcomputer arrangement of claim 1, further comprising an inter-connectable circuit board configured and arranged for connecting to other inter-connectable circuit boards, wherein the controllable switch arrangement and the at least two JTAG signal paths are disposed on the inter-connectable circuit board.

10. The microcomputer arrangement of claim 9, wherein the inter-connectable circuit board is configured and arranged for coupling with another inter-connectable circuit board such that physical access to the controllable switch arrangement is prevented.

11. The microcomputer arrangement of claim 10, wherein the controllable switch arrangement is adapted for routing the data along a JTAG signal path that includes a signal path between the inter-connectable circuit board and the other inter-connectable circuit board.

12. A system for designing a semiconductor device, the system comprising:
a deconfigurable and extendible reference-chip development platform that is programmable, and includes a hardware reconfigurable circuit (300) and a plurality of functional block macros, the hardware reconfigurable circuit comprising:
a microcomputer arrangement as claimed in claim 1;
a collection of functional block macros, at least one of which is obtained from the deconfigurable and extendible reference-chip development platform;
an interface circuit configured and arranged to extend the deconfigurable and extendible reference-chip development platform, including a two-way buffer arrangement and logic circuitry adapted to communicatively couple a plurality of external devices with the reference-chip development platform, and therein provide an extended deconfigurable and extendible reference chip development platform that enables co-development and co-validation of hardware and software;
a synthesizer adapted to cause said at least one of the functional block macros to be represented as a configuration of the hardware reconfigurable circuit; and
wherein the extended deconfigurable and extendible reference-chip development platform is adapted to validate the configuration in the hardware reconfigurable circuit within the extended deconfigurable and extendible reference-chip development platform.

## Patentansprüche

1. Kommunikativ an JTAG-Testknoten (210) gekoppelte Mikrocomputeranordnung (200), wobei die Mikrocomputeranordnung Folgendes umfasst:
eine steuerbare Schalteranordnung (220), die kommunikativ zwischen die JTAG-Testknoten und mindestens zwei JTAG-Signalpfade (240, 246) gekoppelt ist; und
einen Mikrocontroller (205), der kommunikativ an die JTAG-Testknoten gekoppelt ist und programmiert ist, die steuerbare Schalteranordnung zu steuern, Daten zwischen mindestens einem der JTAG-Testknoten und mindestens einem der JTAG-Signalpfade zu leiten, **dadurch gekennzeichnet, dass** der Mikrocontroller:
angeordnet ist, die JTAG-Testknoten zu beobachten, um automatisch ein Testsignal an einem der JTAG-Testknoten zu detektieren; und
programmiert ist, die steuerbare Schalteranordnung als Antwort auf das automatisch detektierte Testsignal zu steuern.

2. Mikrocomputeranordnung nach Anspruch 1, in der der Mikrocontroller programmiert ist, die steuerbare Schalteranordnung zu steuern, Daten entlang eines der JTAG-Signalpfade zwischen den JTAG-Testknoten und einer bestimmten Einrichtung zu leiten, um einen JTAG-Test an der bestimmten Einrichtung durchzuführen.

3. Mikrocomputeranordnung nach Anspruch 1, in der der Mikrocontroller programmiert ist, die JTAG-Testknoten unter Verwendung einer Interrupt-Routine zu beobachten, um automatisch das Testsignal zu detektieren.

4. Mikrocomputeranordnung nach Anspruch 3, in der der Mikrocontroller programmiert ist, die JTAG-Testknoten unter Verwendung einer Vielzahl von Interrupt-Routine zu beobachten, wobei jede der Vielzahl von Interrupt-Routinen angepasst ist, einen der JTAG-Testknoten zu beobachten, um ein Testsignal darauf zu detektieren, der Mikrocontroller angepasst ist, als Antwort darauf, dass die Interrupt-Routine auf dem beobachteten JTAG-Testknoten ein Testsignal detektiert, die Daten zwischen dem beobachteten JTAG-Testknoten und mindestens einem der JTAG-Signalpfade zu leiten.

5. Mikrocomputeranordnung nach Anspruch 4, in der jede Interrupt-Routine einem einzelnen JTAG-Testknoten zugeordnet ist und in der der Mikrocontroller programmiert ist, den steuerbaren Schalter zu steuern, als eine Funktion der Zuordnung der bestimmten Interrupt-Routine, die ein Testsignal detektiert, Daten zwischen einem bestimmten JTAG-Testknoten und einem der JTAG-Signalpfade zu leiten.

6. Mikrocomputeranordnung nach Anspruch 1, in der die steuerbare Schalteranordnung angepasst ist, als Antwort auf den Mikrocontroller Daten entlang eines JTAG-Signalpfades von einem ersten JTAG-Testknoten zu einem zweiten JTAG-Testknoten zu leiten.

7. Mikrocomputeranordnung nach Anspruch 1, in der die steuerbare Schalteranordnung angepasst ist, Daten entlang eines JTAG-Signalpfades von einem ersten JTAG-Testknoten zu einer Einrichtung, die auf die Daten antwortet, zu leiten und eine Antwort der Einrichtung zu einem JTAG-Ausgangsknoten zu leiten.

8. Mikrocomputeranordnung nach Anspruch 7, in der die Einrichtung mindestens eins des Folgenden enthält:
eine FPGA-Einrichtung, eine FPGA-Steckkarte, eine Erweiterungskarte und eine externe Schaltung, die kommunikativ mit dem Mikrocontroller gekoppelt ist.

9. Mikrocomputeranordnung nach Anspruch 1, die weiter eine zwischenschaltbare Leiterplatte umfasst, die konfiguriert und angepasst zum Anschließen an andere zwischenschaltbare Leiterplatten ist, in der die steuerbare Schalteranordnung und mindestens zwei JTAG-Signalpfade auf der zwischenschaltbaren Leiterplatte aufgebracht sind.

10. Mikrocomputeranordnung nach Anspruch 9, in der die zwischenschaltbare Leiterplatte für ein derartiges Koppeln mit einer anderen zwischenschaltbaren Leiterplatte konfiguriert und angeordnet ist, dass physischer Zugang zu der steuerbaren Schalteranordnung verhindert wird.

11. Mikrocomputeranordnung nach Anspruch 10, in der die steuerbare Schalteranordnung angepasst, die Daten entlang eines JTAG-Signalpfades zu leiten, der einen Signalpfad zwischen der zwischenschaltbaren Leiterplatte und der anderen zwischenschaltbaren Leiterplatte enthält.

12. System zum Designen eines Halbleiterbauelements, wobei das System Folgendes umfasst:
eine dekonfigurierbare und erweiterbare Referenz-Chip-Entwicklungsplattform, die programmierbar ist, und eine Hardware-rekonfigurierbare Schaltung (300) und eine Vielzahl von Funktionsblock-Makros enthält, wobei die Hardware-rekonfigurierbare Schaltung (300) Folgendes umfasst:
eine Mikrocomputeranordnung nach Anspruch 1;
eine Sammlung von Funktionsblock-Makros, von denen mindestens eines aus der dekonfigurierbare und erweiterbare Referenz-Chip-Entwicklungsplattform erhalten wird;
eine Interfaceschaltung, die konfiguriert und angeordnet ist, die dekonfigurierbare und erweiterbare Referenz-Chip-Entwicklungsplattform zu erweitern, einschließlich einer Zweiwegepufferanordnung und Logikschaltkreisen, die angepasst sind, kommunikativ eine Vielzahl externer Einrichtungen mit der Referenz-Chip-Entwicklungsplattform zu koppeln und darin eine erweiterte dekonfigurierbare und erweiterbare Referenz-Chip-Entwicklungsplattform zu schaffen, die Co-Entwicklung und Co-Validierung von Hardware und Software ermöglicht;
einen Synthesizer, der angepasst ist, zu verursachen, dass der genannte mindestens eine der Funktionsblock-Makros als eine Konfiguration der Hardware-rekonfigurierbaren Schaltung repräsentiert wird; und
worin die erweiterte dekonfigurierbare und erweiterbare Referenz-Chip-Entwicklungsplattform angepasst ist, die Konfiguration in der Hardware-rekonfigurierbaren Schaltung innerhalb der erweiterten dekonfigurierbaren und erweiterbaren Referenz-Chip-Entwicklungsplattform zu validieren.

## Revendications

1. Montage de micro-ordinateur (200) qui est couplé d'une manière communicative à des points communs d'essai de JTAG (210), le montage de micro-ordinateur comprenant:
un montage de commutation commandable (220) qui est couplé d'une manière communicative entre les points communs d'essai de JTAG et au moins deux chemins de signal de JTAG (240, 246); et
un microcontrôleur (205) qui est couplé d'une manière communicative aux points communs d'essai de JTAG et qui est programmé de manière à commander le montage de commutation commandable pour acheminer des données entre au moins un des points communs d'essai de JTAG et au moins un des chemins de signal de JTAG, **caractérisé en ce que** le microcontrôleur est:
agencé de manière à contrôler les points communs d'essai de JTAG pour détecter automatiquement un signal d'essai à un des points communs d'essai de JTAG; et
programmé de manière à commander le montage de commutation commandable en réaction au signal d'essai automatiquement détecté.

2. Montage de micro-ordinateur selon la revendication 1, dans lequel le microcontrôleur est programmé de manière à commander le montage de commutation commandable pour acheminer des données entre les points communs d'essai de JTAG et un dispositif particulier le long d'un des chemins de signal de JTAG pour exécuter un essai de JTAG sur le dispositif particulier.

3. Montage de micro-ordinateur selon la revendication 1, dans lequel le microcontrôleur est programmé de manière à contrôler les points communs d'essai de JTAG à l'aide d'un sous-programme d'interruption pour détecter automatiquement le signal d'essai.

4. Montage de micro-ordinateur selon la revendication 3, dans lequel le microcontrôleur est programmé de manière à contrôler les points communs d'essai de JTAG à l'aide d'une pluralité de sous-programmes d'interruption, chacun de la pluralité de sous-programmes d'interruption étant adapté à contrôler un des points communs d'essai de JTAG pour y détecter un signal d'essai, le microcontrôleur étant adapté à acheminer les données entre le point commun d'essai contrôlé de JTAG et au moins un des signaux de chemin de JTAG en réaction au sous-programme d'interruption détectant un signal d'essai sur le point commun d'essai contrôlé de JTAG.

5. Montage de micro-ordinateur selon la revendication 4, dans lequel chaque sous-programme d'interruption est assigné à un point commun d'essai unique de JTAG et dans lequel le microcontrôleur est programmé de manière à commander le commutateur commandable pour acheminer des données entre un point commun d'essai particulier de JTAG et un des chemins de signal de JTAG en fonction de l'assignation du sous-programme d'interruption particulier qui détecte un signal d'essai.

6. Montage de micro-ordinateur selon la revendication 1, dans lequel le montage de commutation commandable est adapté à acheminer des données le long du chemin de signal de JTAG à partir d'un premier point commun d'essai de JTAG vers un second point commun d'essai de JTAG en réaction au microcontrôleur.

7. Montage de micro-ordinateur selon la revendication 1, dans lequel le montage de commutation commandable est adapté à acheminer des données le long d'un chemin de signal de JTAG à partir d'un premier point commun d'essai de JTAG vers un dispositif qui répond aux données et à acheminer une réaction du dispositif vers un point commun de sortie d'essai de JTAG.

8. Montage de micro-ordinateur selon la revendication 7, dans lequel le dispositif inclut au moins un de:
un dispositif de FPGA, une carte enfichable de FPGA, une carte d'extension et un circuit externe qui est couplé d'une manière communicative au microcontrôleur.

9. Montage de micro-ordinateur selon la revendication 1, comprenant encore une carte imprimée susceptible d'interconnexion qui est configurée et qui est agencée de manière à être connectée à d'autres cartes imprimées susceptibles d'interconnexion où le montage de commutation commandable et les au moins deux chemins de signal de JTAG sont disposés sur la carte imprimée susceptible d'interconnexion.

10. Montage de micro-ordinateur selon la revendication 9, dans lequel la carte imprimée susceptible d'interconnexion est configurée et est agencée de manière à être couplée à une autre carte imprimée susceptible d'interconnexion de telle façon qu'un accès physique au montage de commutation commandable soit empêché.

11. Montage de micro-ordinateur selon la revendication 10, dans lequel le montage de commutation commandable est adapté à acheminer les données le long d'un chemin de signal de JTAG qui inclut un chemin de signal entre la carte imprimée susceptible d'interconnexion et l'autre carte imprimée susceptible d'interconnexion.

12. Système pour concevoir un dispositif à semi-conducteur, le système comprenant:
une plate-forme déconfigurable et extensible de développement de puce de référence qui est programmable et qui inclut un circuit reconfigurable de matériel (300) et une pluralité de macros fonctionnels de bloc, le circuit reconfigurable de matériel comprenant:
un montage de micro-ordinateur selon la revendication 1;
une collection de macros fonctionnels de bloc dont au moins un est obtenu de la plate-forme déconfigurable et extensible de développement de puce de référence;
un circuit d'interface qui est configuré et qui est agencé de manière à agrandir la plate-forme déconfigurable et extensible de développement de puce de référence comprenant un montage tampon bidirectionnel et des circuits logiques qui sont adaptés à coupler d'une manière communicative une pluralité de dispositifs externes à la plate-forme de développement de puce de référence et qui y fournissent une plate-forme déconfigurable et extensible agrandie de développement de puce de référence qui permet le co-développement et la co-validation de matériel et de logiciel;
un synthétiseur qui est adapté à effectuer que ledit au moins un des macros fonctionnels de bloc est représenté en tant qu'une configuration du circuit reconfigurable de matériel; et
dans lequel la plate-forme déconfigurable et extensible agrandie de développement de puce de référence est adaptée à valider la configuration dans le circuit reconfigurable de matériel à l'intérieur de la plate-forme déconfigurable et extensible agrandie de développement de puce de référence.
